# EUROPEAN PATENT SPECIFICATION

(11) **EP 3 396 683 B1**
(45) Date of publication and mention of the grant of the patent: **11.05.2022**
(21) Application number: 16878382.7
(22) Date of filing: 08.12.2016
(51) Int. Cl.: H01B 7/06, G06F 3/041, H01B 7/08, H01B 13/00, H01B 13/008

(54) **STRETCHING-CONTRACTING WIRING SHEET, PRODUCTION METHOD AND PRODUCTION DEVICE THEREFOR, AND STRETCHING-CONTRACTING TOUCH SENSOR SHEET**
STRECK-/-KONTRAKTIONSVERDRAHTUNGSSCHICHT, HERSTELLUNGSVERFAHREN UND HERSTELLUNGSVORRICHTUNG DAFÜR SOWIE STRECK-/-KONTRAKTIONSBERÜHRUNGSSENSORSCHICHT
FEUILLE DE CÂBLAGE D'ÉTIRAGE-CONTRACTION, PROCÉDÉ DE PRODUCTION ET DISPOSITIF DE PRODUCTION ASSOCIÉS, ET FEUILLE DE CAPTEUR TACTILE D'ÉTIRAGE-CONTRACTION

(30) Priority: 24.12.2015 JP 2015250943
(43) Date of publication of application: 31.10.2018
(73) Proprietor: Tokusen Kogyo Co., Ltd, Ono-City, Hyogo 675-1361 (JP)
(72) Inventor: YOSHIDA, Manabu, Tsukuba-shi Ibaraki 305-8565 (JP); UEMURA, Sei, Tsukuba-shi Ibaraki 305-8565 (JP); NOBESHIMA, Taiki, Tsukuba-shi Ibaraki 305-8565 (JP); YAMASHITA, Masato, Ono-shi Hyogo 675-1361 (JP); SUMIMOTO, Shin, Ono-shi Hyogo 675-1361 (JP)
(74) Representative: Graf von Stosch Patentanwaltsgesellschaft mbH
(86) International application number: PCT/JP2016/086507
(87) International publication number: WO 2017/110490

(56) References cited:
- EP-A1- 3 261 097
- WO-A1-2012/170101
- WO-A1-2015/029955
- WO-A1-2016/133065
- JP-A- 2018 010 504
- US-A1- 2011 026 233
- US-A1- 2014 138 637
- US-A1- 2019 018 511

## Description

### Technical Field

The present invention relates to a stretchable contractible wiring sheet having an excellent stretchability/contractibility and including a lead between two stretchable contractible elastomer sheets and a producing method and a producing apparatus for the same, and a stretchable contractible touch sensor sheet.

### Background Art

In recent years, demands for stretchable contractible wiring sheets have been increasing in various fields including, for example, antennas and wirings for RFID devices required to have flexibility, wirings for motion analysis sensors in the sport science, wearable heart rate/electrocardiogram monitors, wiring sheets for movable parts of robots, touch sensor sheets configured to send instructions to computers, and wiring sheets for bendable sensors to be worn on fingers, elbow joints, and knee joints for remotely controlling robots. These stretchable contractible wiring sheets are required to have an excellent stretchability/contractibility and to undergo a small resistance value change along with stretching and contracting.

In this context, there has been a proposal for producing a stretchable contractible conductive rubber by dispersing, for example, an ionic liquid and carbon nanotube in a rubber (see PTL 1).

However, in this proposal, materials such as carbon nanotube for forming the stretchable contractible conductor are expensive and need to be contained at extremely high content ratios in order to obtain a sufficient conductivity. Hence, there is a problem of running up the production cost even more.

There has also been a proposal for producing a stretchable contractible circuit board by pasting a copper wiring having a wavy structure on an elastomer (see PTL 2).

However, in this proposal, the copper wiring having a wave pattern is formed by etching a copper foil that is laminated on the elastomer. Therefore, there is a problem that the production process is complicated. Further, when this stretchable contractible circuit board is used as a touch sensor sheet, the copper wiring is elongated against its wavy structure. Therefore, there is a problem that the copper wiring cannot easily change its shape in a manner to conform to a touch operation, making it impossible to obtain a sufficient operation feeling and a sufficient sensitivity.

There has also been a proposal for disposing wirings formed of a urethane rubber and silver powder on the lower surface of an elastomer sheet formed of an ester-based urethane rubber (see PTL 3).

However, in this proposal, there is a problem that the production cost is high, because leads having stretchability/contractibility are formed individually by encapsulating the urethane rubber with the silver powder. Further, there is a problem that flexibility and durability are poor, because if the formed leads undergo shape changes along with elongation and bending operations to make electric contact between silver powder particles discontinuous at any portion, the leads cannot serve the function.

There has also been proposed a conductive fiber sheet obtained by disposing an antenna for a booster formed of conductive fibers in a manner to face an antenna of an IC chip in a non-bonded state (see PTL 4).

However, in this proposal, there is a problem that the conductive fibers are
expensive, and even more cost increase is incurred by the conductive fiber sheet that is wasted in cutting works performed to conform to various antenna shapes.

US 2011/026233 discloses to generate a conductive sheet having zigzag-shaped conductor tracks (10) interposed between upper and lower films (21 and 23) to be stretched or contracted when the elastic cable 1 is deformed due to external stresses. The zigzag pattern is accomplished by an aligning unit " including a base frame 41 movable in a lateral direction W perpendicular to the feeding direction T of the film 20".

### Citation List

### Patent Literature

PTL 1: International Publication No. WO 2009/102077
PTL 2: Japanese Patent Application Laid-Open (JP-A) No. 2013-187380
PTL 3: JP-A No. 2011-34822
PTL 4: JP-A No. 2013-206080

### Summary of Invention

### Technical Problem

The present invention aims for solving the various problems in the related art and providing a high-stretchability/contractibility stretchable contractible wiring sheet that can be produced easily at low costs, has a high flexibility, a high durability, and a high conformity to an external force, and undergoes a small resistance value change along with stretching and contracting and a producing method and a producing apparatus for the same, and a stretchable contractible touch sensor sheet.

### Solution to Problem

Means for solving the above problems are as follows.
<1> A stretchable contractible wiring sheet according to independent claim 1.
<2> The stretchable contractible wiring sheet according to <1>, wherein a cross-sectional shape of the lead in a diameter direction is a circular shape.
<3> The stretchable contractible wiring sheet according to <1> or <2>, wherein a diameter of the lead is at most 50 micrometers.
<4> The stretchable contractible wiring sheet according to any one of <1> to <3>, wherein a Young's modulus of the lead is at least 150 GPa.
<5> The stretchable contractible wiring sheet according to any one of <1> to <4>, wherein a wave height of the wavy shape is from 20 micrometers through 5 mm.
<6> The stretchable contractible wiring sheet according to any one of <1> to <5>, wherein a ratio A/B is from 0.05 through 0.5, where A represents a curvature radius of wave crests of waves in the wavy shape and B represents a periodic pitch interval between adjoining waves of the waves in the wavy shape.
<7> A method for producing a stretchable contractible wiring sheet according to claim 7.
<8> An apparatus for producing a stretchable contractible wiring sheet according to claim 8.
<9> A stretchable contractible touch sensor sheet according to claim 9.
<10> The stretchable contractible touch sensor sheet according to <9>, wherein a haze value of the stretchable contractible touch sensor sheet is at most 60% or lower.

### Advantageous Effects of Invention

The present invention can solve the various problems in the related art and provide a high-stretchability/contractibility stretchable contractible wiring sheet that can be produced easily at low costs and has a high flexibility, a high durability, and a high conformity to an external force, and a producing method and a producing apparatus for the same, and a stretchable contractible touch sensor sheet.

### Brief Description of Drawings

FIG. 1A is a view illustrating a sheet upper surface of a stretchable contractible wiring sheet;
FIG. 1B is a cross-sectional view illustrating a sheet cross-section of a stretchable contractible sheet;
FIG. 1C is a diagram illustrating a length L₁ of a lead 2 in a state of being interposed between a first elastomer sheet 1a and a second elastomer sheet 1b during unloading;
FIG. 1D is a diagram illustrating a length L₂ of a lead 2 in a state of being unloaded by being taken out to the outside with removal of a first elastomer sheet 1a and a second elastomer sheet 1b with, for example a solvent;
FIG. 2A is a graph plotting a relationship between an initial elongation rate of a first elastomer sheet 1a and a second elastomer sheet 1b during pasting, and a wave number and a wave height of a wavy shape;
FIG. 2B is a graph plotting a relationship between a diameter of a lead 2, and a wave number and a wave height of a wavy shape;
FIG. 2C is a graph plotting a relationship between materials forming a lead 2, and a wave number and a wave height of a wavy shape;
FIG. 2D is a graph plotting a relationship between elastic moduli of materials forming a lead 2, and a curvature radius of wave crests in a wavy shape;
FIG. 3A is a diagram illustrating a correlation between elastic moduli of materials forming a lead 2, and a curvature radius of wave crests of waves in the wavy shape;
FIG. 3B is an enlarged diagram of a wavy shape having a small curvature radius based on a small elastic modulus, illustrating an encircled portion in FIG. 3A in an enlarging manner;
FIG. 3C is an enlarged diagram of a wavy shape having a large curvature radius based on a large elastic modulus, illustrating an encircled portion in FIG. 3A in an enlarging manner;
FIG. 4A is a diagram illustrating a microscopic image of a wavy shape of a lead 2 in a case where a stretchable contractible wiring sheet 10 is produced using a piano wire having a diameter of 9 micrometers as a material having a large elastic modulus;
FIG. 4B is a diagram illustrating a microscopic image of a wavy shape of a lead 2 in a case where a stretchable contractible wiring sheet 10 is produced using a copper wire having a diameter of 30 micrometers as a material having a small elastic modulus;
FIG. 5A is a view (1) illustrating a step of producing a stretchable contractible wiring sheet 10;
FIG. 5B is a view (2) illustrating a step of producing a stretchable contractible wiring sheet 10;
FIG. 5C is a view (3) illustrating a step of producing a stretchable contractible wiring sheet 10;
FIG. 6 is a view illustrating an example of an apparatus for producing a stretchable contractible wiring sheet;
FIG. 7A is a view illustrating a configuration example of a stretchable contractible touch sensor sheet; and
FIG. 7B is a view illustrating a configuration example of a capacitance-type touch sensor;
FIG. 8 is a graph plotting resistance value changes of a stretchable contractible wiring sheet according to an Example;
FIG. 9A is a view illustrating a lighting state of a LED device after elongation;
FIG. 9B is a view illustrating a lighting state of a LED device before elongation;
FIG. 10A is a view illustrating a state of observing whether a light reflecting medium is visible through a stretchable contractible wiring sheet;
FIG. 10B is a view illustrating a state of observing whether a light emitting medium is visible through a stretchable contractible wiring sheet;
FIG. 11 is a view illustrating a state of observing whether a touch sensor undergoes shape change flexibly;
FIG. 12A is a view illustrating a lighting state before bending of a touch sensor; and
FIG. 12B is a view illustrating a lighting state after bending of a touch sensor.

### Description of Embodiments

### (Stretchable contractible wiring sheet)

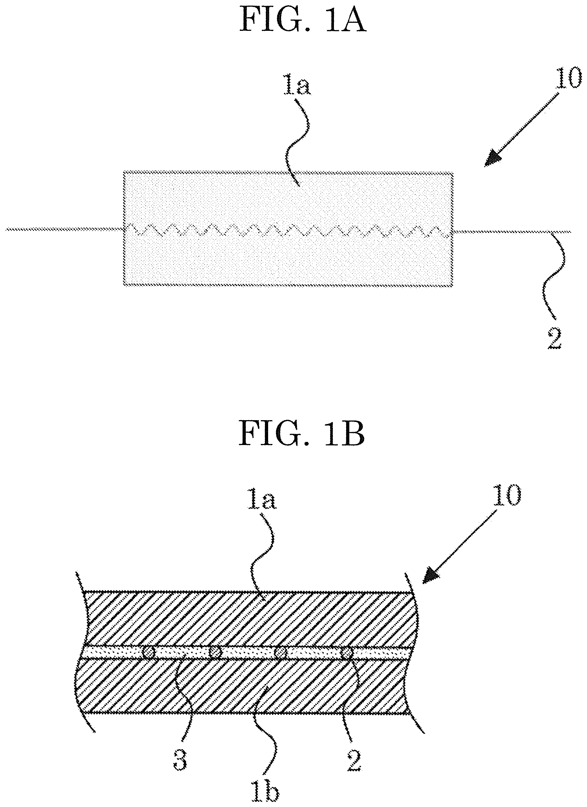

A stretchable contractible wiring sheet 10 according to an embodiment of the present invention will be described with reference to FIG. 1A and FIG. 1B. FIG. 1A is a view illustrating a sheet upper surface of the stretchable contractible wiring sheet. FIG. 1B is a cross-sectional view illustrating a sheet cross-section of the stretchable contractible sheet.

As illustrated in FIG. 1A and FIG. 1B, the stretchable contractible wiring sheet 10 includes a first elastomer sheet 1a that is stretchable and contractible, a second elastomer sheet 1b that is stretchable and contractible, and bonded on the first elastomer sheet 1a in a manner to face the first elastomer sheet 1a, and a lead 2 interposed between the first elastomer sheet 1a and the second elastomer sheet 1b.

The first elastomer sheet 1a and the second elastomer sheet 1b are not particularly limited and may be appropriately selected depending on the intended purpose, so long as the first elastomer sheet 1a and the second elastomer sheet 1b elastically deform and undergo stretching and contracting. Sheets formed of known elastomer materials can be used. Examples include natural rubbers, diene-based rubbers, non-diene-based rubbers, urethane-based elastomers, styrene-based elastomers, and silicon-based elastomers.

When the stretchable contractible wiring sheet 10 is used as a stretchable contractible touch sensor sheet, display on the supporting side of the stretchable contractible wiring sheet 10 needs to be visible from the upper surface side of the stretchable contractible wiring sheet 10. Hence, the first elastomer sheet 1a and the second elastomer sheet 1b need to have transparency. In this case, as the first elastomer sheet 1a and the second elastomer sheet 1b, sheets formed of known elastomer materials having transparency can be used, and, for example, known urethane-based elastomer sheets, known acrylic-based elastomer sheets, and known silicon-based elastomer sheets can be used.

In this specification, the term "transparency" means that the visible light transmittance is 50% or higher.

The limit elongation rate of the first elastomer sheet 1a and the second elastomer sheet 1b is not particularly limited. However, because the stretchable contractible wiring sheet 10 can have a higher stretchability/contractibility as the limit elongation rate is higher, the limit elongation rate is preferably 50% (1.5 times longer than the equilibrium length) or higher, more preferably 300% (4 times longer than the equilibrium length) or higher, and particularly preferably 500% (6 times longer than the equilibrium length) or higher.

In this specification, the term "limit elongation rate" refers to an elongation rate at which the sheet is torn when the sheet is elongated.

The thickness of the first elastomer sheet 1a and the second elastomer sheet 1b is not particularly limited but is preferably 5 micrometers or greater in terms of providing the sheets with stiffness enough for the lead 2 to be interposed in a wavy shape periodically curving in-plane in the facing surfaces of these sheets, although the preferable thickness depends on the material that forms the sheets. That is, when the thickness is less than 5 micrometers, the lead 2 interposed between these sheets during production in a manner that the lead 2 has a wavy shape periodically curving in-plane in the facing surfaces cannot suppress the wavy shape of the lead 2 from having a protruding posture in the thickness direction of these sheets, which may make it difficult to provide the lead 2 with a wavy shape periodically curving in-plane in the facing surfaces of these sheets. However, even when such a posture of the lead 2 cannot be suppressed by the stiffness imparted by the thickness, it may be possible to produce the lead 2 to have a wavy shape periodically curving in-plane in the facing surfaces of these sheets, by interposing the lead 2 between these sheets while supporting these sheets from above and below with, for example, plates having a high flatness so as to impart stiffness to these sheets.

The upper limit of the thickness of the first elastomer sheet 1a and the second elastomer sheet 1b is not particularly limited but is preferably about 150 micrometers in terms of imparting a necessary flexibility and a necessary transparency to the stretchable contractible wiring sheet 10.

As the method for bonding the first elastomer sheet 1a and the second elastomer sheet 1b, there is a method of forming a viscous layer 3 on at least any one of the facing surfaces of these sheets to paste these sheets with each other.

The physical properties of the viscous layer 3 such as flexibility and stretchability/contractibility after cured are appropriately selected so as not to inhibit the physical properties of the first elastomer sheet 1a and the second elastomer sheet 1b such as flexibility and stretchability/contractibility. Examples of the material forming the viscous layer include known rubber-based tackifiers, known urethane-based tackifiers, known acrylic-based tackifiers, and known silicon-based tackifiers. When the viscous layer is required to have transparency, it is preferable to use known urethane-based tackifiers, known acrylic-based tackifiers, and known silicon-based tackifiers.

The viscous force of the viscous layer 3 is not particularly limited but is preferably at least from 0.5 N/cm through 10 N/cm. When the viscous force is less than 0.5 N/cm, it may be difficult to provide the lead 2 with a periodic wavy shape during production. When the viscous force is greater than 10 N/cm, there is a risk that a load applied to the wiring during stretching and contracting may be high, to break the wiring.

The lead 2 is interposed between the first elastomer sheet 1a and the second elastomer sheet 1b in a state of having a wavy shape periodically curving in-plane in the facing surfaces of the first elastomer sheet 1a and the second elastomer sheet 1b and being biased in a direction to restore to a rod-like shape from the wavy shape during unloading.

Disposing the lead 2 in this state between the first elastomer sheet 1a and the second elastomer sheet 1b leads to formation of a high-stretchability/contractibility stretchable contractible wiring sheet 10 that has a high flexibility, a high durability and a high conformity to an external force. Furthermore, in this lead 2, the length of a path through which electricity flows during elongation remains unchanged from the equilibrium length during unloading, and the resistance value is stable.

The method for forming the lead 2 in this routing state will be described specifically in a below-described section for a producing method.

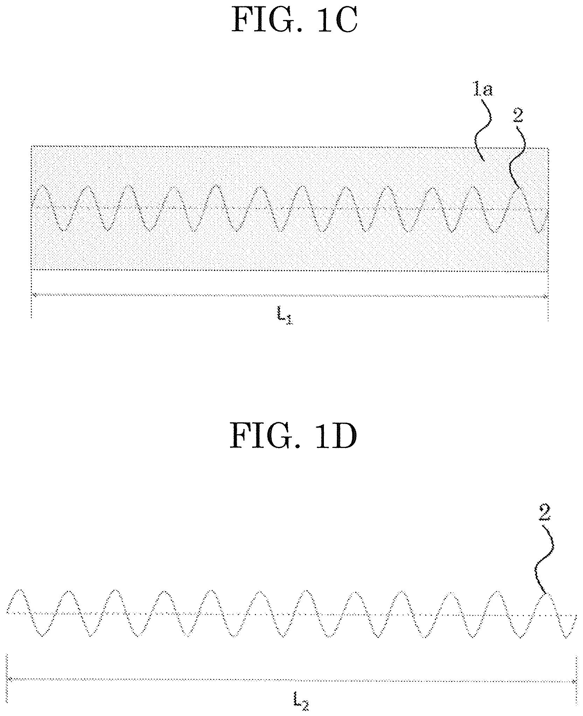

It is possible to confirm that the lead 2 is biased in a direction to restore to the rod-like shape from the wavy shape in the stretchable contractible wiring sheet 10, based on that the length of the lead 2 in a state of being unloaded by being taken out to the outside with removal of the first elastomer sheet 1a and the second elastomer sheet 1b with, for example a solvent is longer than the length of the lead 2 in a state of being interposed between the first elastomer sheet 1a and the second elastomer sheet 1b during unloading. That is, in this specification, "being biased in a direction to restore to the rod-like shape from the wavy shape" means, for example, that a relationship represented by the following formula: L₁<L₂ (m) is satisfied, where L₁ represents the length of the lead 2 in a state of being interposed between the first elastomer sheet 1a and the second elastomer sheet 1b during unloading as illustrated in FIG. 1C, and L₂ represents the length of the lead 2 in a state of being unloaded by being taken out to the outside with removal of the first elastomer sheet 1a and the second elastomer sheet 1b with, for example, a solvent as illustrated in FIG. 1D.

In this specification, the term "unloading" refers to a state that shape changes such as elongation and bending are not applied to the stretchable contractible wiring sheet 10.

The cross-sectional shape of the lead 2 is not particularly limited but is preferably a circular shape and may be an elliptical shape or a track shape, in terms of avoiding lead breaking due to local stress concentration during elongation.

The diameter of the lead 2 is not particularly limited but is preferably at most 50 micrometers, more preferably 25 micrometers, and particularly preferably 12 micrometers in terms of imparting transparency to the stretchable contractible wiring sheet 10. The diameter of the lead 2 when the cross-sectional shape of the lead 2 is other than a circular shape refers to the diameter at a position at which that cross-sectional shape has the longest dimension. The lower limit of the diameter of the lead 2 is about 1 micrometer.

In terms of imparting transparency to the stretchable contractible wiring sheet 10, the diameter of the lead 2 is set extremely thin as described above. Hence, there is a need for selecting materials and setting the wavy shape in a manner that the lead 2 does not break when shape changes such as elongation and bending are applied to the stretchable contractible wiring sheet 10.

In the case of producing the stretchable contractible wiring sheet 10 by a producing method described below, what are considered the factors determining a waveform (a curvature radius of wave crests), a periodic pitch interval between adjoining waves (a length of one period), a wave number per unit length of 1 mm (a number of waves in one period), and a wave height of the wavy shape of the lead 2 include the diameter of the lead 2, the initial elongation rate of the first elastomer sheet 1a and the second elastomer sheet 1b during pasting, the materials forming the lead 2, and the elastic moduli of the materials.

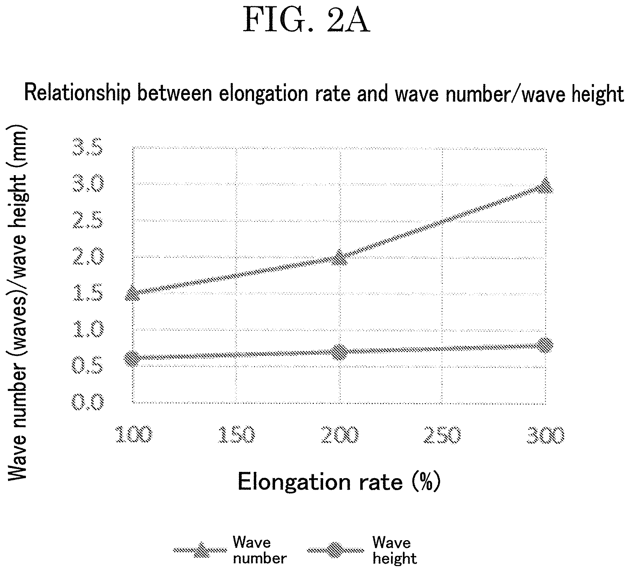

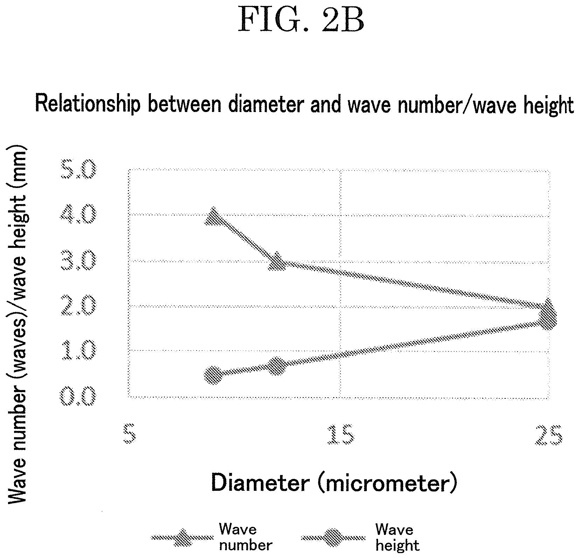

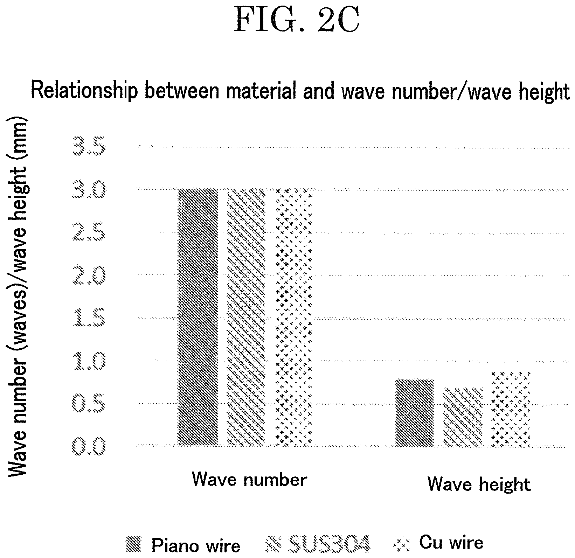

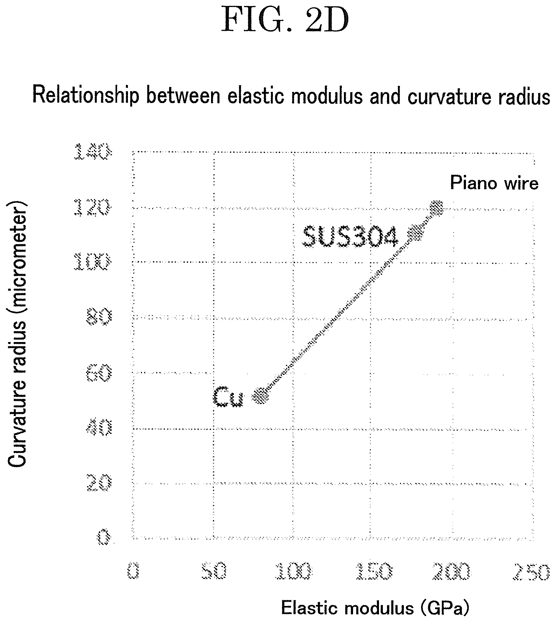

The relationships between the factors are illustrated in FIG. 2A to FIG. 2D. FIG. 2A is a graph plotting the relationship between the initial elongation rate of the first elastomer sheet 1a and the second elastomer sheet 1b during pasting, and the wave number and the wave height of the wavy shape. FIG. 2B is a graph plotting the relationship between the diameter of the lead 2, and the wave number and the wave height of the wavy shape. FIG. 2C is a graph plotting the relationship between the materials forming the lead 2, and the wave number and the wave height of the wavy shape. FIG. 2D is a graph plotting the relationship between the elastic moduli of the materials forming the lead 2, and the curvature radius of the wave crests of the waves in the wavy shape. The kinds of the lead are presented in Table 1 below. A cross-section of each lead taken in the diameter direction has a circular shape.

**Table 1**

| Material used for extra fine wire | Modulus of longitudinal elasticity (GPa) | Resistivity (microhm-cm) |
|---|---|---|
| Piano wire | 190 | 22 |
| SUS304 wire | 177 | 81 |
| Copper wire | 80-90 | 1.7 |

The wave number and the wave height of the wavy shape of the lead 2 are almost not dependent on the materials forming the lead 2 as plotted in FIG. 2C, but are dependent on the initial elongation rate of the first elastomer sheet 1a and the second elastomer sheet 1b during pasting and the diameter of the lead 2 as plotted in FIG. 2A and FIG. 2B.

Further, there is a strong correlation between the elastic moduli of the materials forming the lead 2 and the curvature radius of the wave crests of the waves in the wavy shape, as plotted in FIG. 2D.

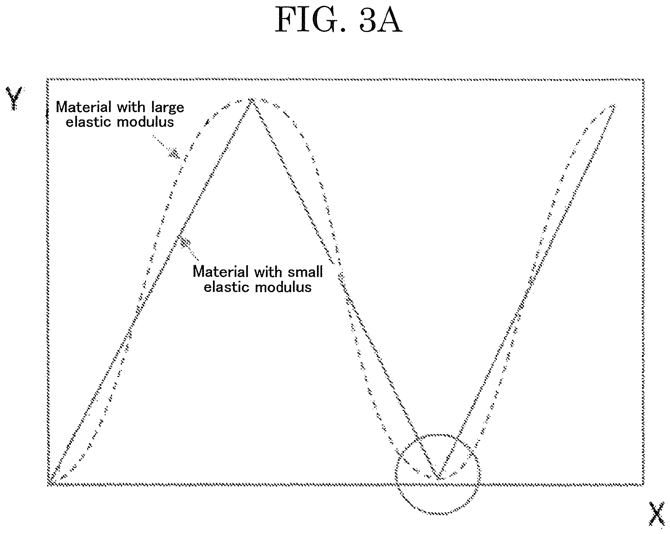

That is, a wavy shape has a small curvature radius when the elastic modulus is small, and a wavy shape has a large curvature radius when the elastic modulus is large, as illustrated in FIG. 3A. FIG. 3A is a diagram illustrating a correlation between the elastic moduli of the materials forming the lead 2, and the curvature radius of the wave crests of the waves in the wavy shape.

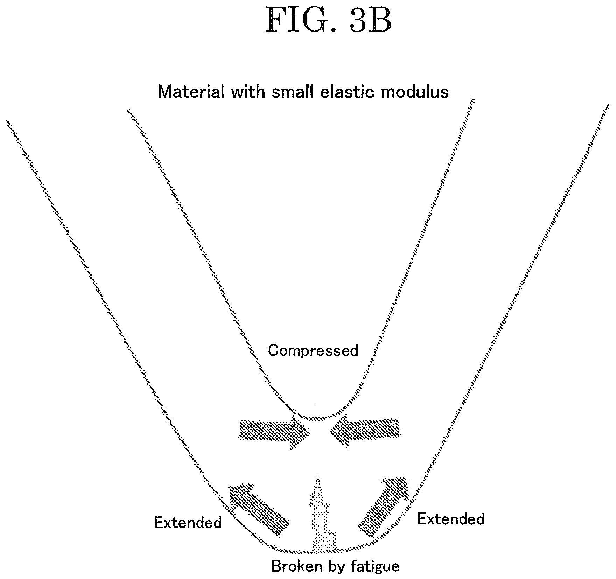

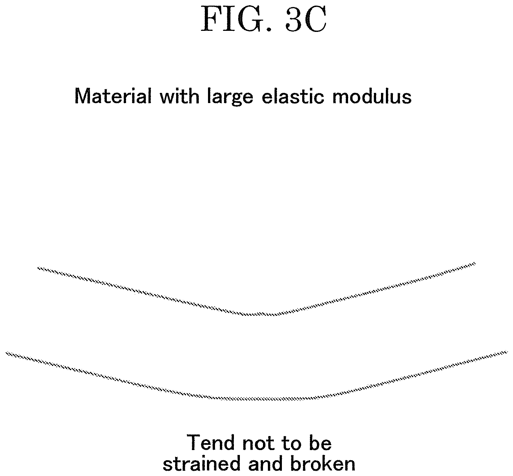

With a wavy shape having a small curvature radius based on a small elastic modulus, the lead 2 is likely to break when shape changes such as elongation and bending are applied to the stretchable contractible wiring sheet 10 as illustrated in FIG. 3B in an enlarging manner. With a wavy shape having a large curvature radius based on a large elastic modulus, the lead 2 is less likely to break when shape changes such as elongation and bending are applied to the stretchable contractible wiring sheet 10 as illustrated in FIG. 3C in an enlarging manner. FIG. 3B is an enlarged diagram of a wavy shape having a small curvature radius based on a small elastic modulus, illustrating an encircled portion in FIG. 3A in an enlarging manner. FIG. 3C is an enlarged diagram of a wavy shape having a large curvature radius based on a large elastic modulus, illustrating an encircled portion in FIG. 3A in an enlarging manner.

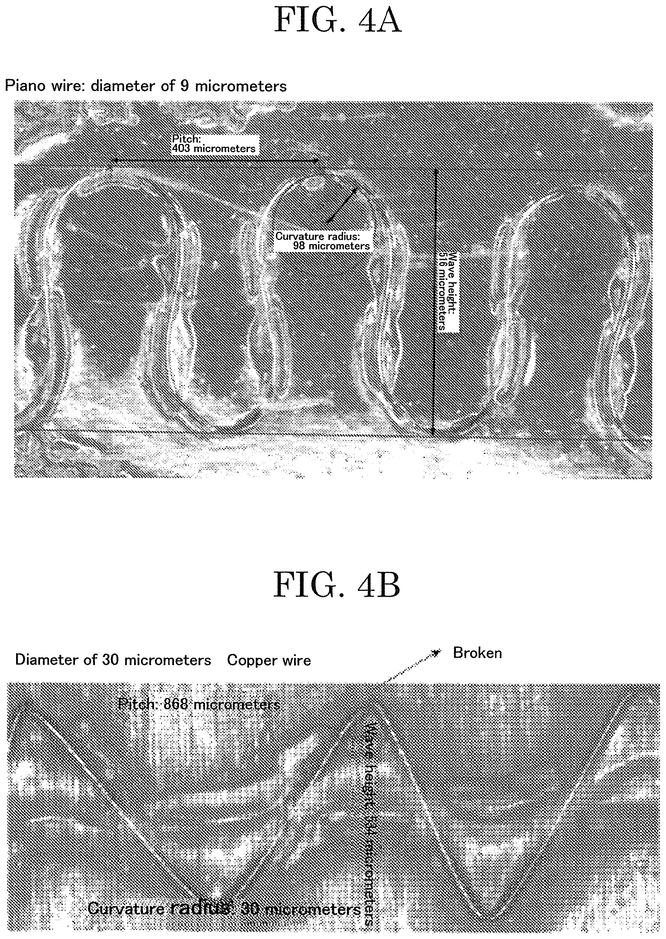

Microscopic images of the wavy shape of the lead 2 in a case where the stretchable contractible wiring sheet 10 was actually produced using a piano wire having a diameter of 9 micrometers as a material having a large elastic modulus and in a case where the stretchable contractible wiring sheet 10 was actually produced using a copper wire having a diameter of 30 micrometers as a material having a small elastic modulus are illustrated in FIG. 4A and FIG. 4B. FIG. 4A is a diagram illustrating a microscopic image of the wavy shape of the lead 2 in the case where the stretchable contractible wiring sheet 10 was produced using a piano wire having a diameter of 9 micrometers as a material having a large elastic modulus. FIG. 4B is a diagram illustrating a microscopic image of the wavy shape of the lead 2 in the case where the stretchable contractible wiring sheet 10 was produced using a copper wire having a diameter of 30 micrometers as a material having a small elastic modulus. These examples of producing the stretchable contractible wiring sheet 10 were on the same conditions, except for the materials forming the lead 2.

As illustrated in FIG. 4A and FIG. 4B, it was actually observed that the piano wire having a large elastic modulus did not break due to the large curvature radius, whereas that the copper wire having a small elastic modulus broke due to the small curvature radius. In the case of using the copper wire having a small elastic modulus, the degree of latitude of selecting the initial elongation rate of the first elastomer sheet 1a and the second elastomer sheet 1b during pasting and the diameter is significantly limited.

Hence, in terms of keeping the curvature radius of the wave crests of the waves in the wavy shape large, it is preferable that the lead 2 have a Young's modulus (modulus of longitudinal elasticity) of at least 150 GPa, as an index for the same physical property as the elastic modulus of a material for a lead. The upper limit of the Young's modulus (modulus of longitudinal elasticity) is about 500 GPa. For measuring the Young's modulus (modulus of longitudinal elasticity), a tensile test of the lead 2 is performed to obtain a stress-strain curve. The Young's modulus can be calculated by obtaining the slope of a straight line portion of the stress-strain curve.

When the curvature radius of the wave crests of the waves in the wavy shape is assumed to be A and the periodic pitch interval between adjoining waves of the waves in the wavy shape is assumed to be B, the ratio A/B is not particularly limited but is preferably from 0.05 through 0.5. That is, when the ratio A/B is less than 0.05, a bent portion has a large strain that may break the lead. When the ratio A/B is greater than 0.5, it may be difficult to maintain a periodic wavy shape.

The ratio A/B of the piano wire illustrated in FIG. 4A is about 0.14, and the ratio A/B of the copper wire illustrated in FIG. 4B is about 0.03.

The wave height of the wavy shape is not particularly limited but is preferably from 20 micrometers through 5 mm. That is, when the wave height is less than 20 micrometers, the lead 2 has an approximately rod-like shape, which may reduce the elongatable range of the stretchable contractible wiring sheet 10. When the wave height is greater than 5 mm, the lead 2 in the stretchable contractible wiring sheet 10 becomes more visible, which may make it impossible to obtain a necessary transparency.

The waveform of the wavy shape can be recognized from outside of the stretchable contractible wiring sheet 10 with a known optical microscope, a known digital microscope, a known electron microscope, and a known X-ray microscope.

The resistivity of the lead 2 is not particularly limited, may be appropriately selected depending on the intended purpose, and is about from 1.0×10⁻⁶ Ω·cm through 1.0×10⁻³ Ω·cm.

The material forming the lead 2 is not particularly limited and may be appropriately selected considering each of the properties described above. Examples of the material include known metal wires such as stainless steel represented by SUS304, tungsten, tungsten alloys, and carbon steel, and carbon fiber. Among the metal wires, those that have a relatively high resistivity such as the above-described piano wire and SUS304 wire may be used with plating on the surface with a metal having a low resistivity, such as copper and silver.

The stretchable contractible wiring sheet 10 includes one lead 2. However, a plurality of leads 2 may be formed side by side.

The stretchable contractible wiring sheet 10 configured as described above has a high flexibility, a high durability, and a high conformity to an external force, undergoes a small resistance value change along with shape change, and can be produced easily at low costs by a producing method described below. Therefore, use of the stretchable contractible wiring sheet 10 as a wiring sheet can be expected in a wide range of fields such as wirings for RFID devices required to have flexibility, wirings for motion analysis sensors in the sport science, wirings for heart rate/electrocardiogram monitors, wirings for movable parts of robots, and wirings for touch sensor panels configured to send instructions to computers.

### (Method for producing stretchable contractible wiring sheet)

A method for producing a stretchable contractible wiring sheet of the present invention includes an elongating step, a pasting step, and an unloading step, and further includes other steps as needed.

The elongating step is a step of elongating a first elastomer sheet and a second elastomer sheet in one elongating direction in a state that the first elastomer sheet and the second elastomer sheet face each other, where an adhesive layer is formed on at least any one of facing surfaces of the first elastomer sheet and the second elastomer sheet.

The method for elongating these sheets in one elongating direction is not particularly limited. Examples of the method include a method of applying a tension to these sheets using a known tensile force device.

The elongation rate (initial elongation rate) of the first elastomer sheet and the second elastomer sheet in the elongating step is not particularly limited and may be appropriately selected depending on the intended purpose, so long as the elongation rate is lower than the limit elongation rate of these sheets.

The pasting step is a step of disposing a lead having a rod-like shape along the elongating direction between the first elastomer sheet and the second elastomer sheet that face each other, and pasting the first elastomer sheet and the second elastomer sheet with each other in a state that the lead is interposed between the first elastomer sheet and the second elastomer sheet.

The method for disposing the lead along the elongating direction between the first elastomer sheet and the second elastomer sheet that face each other is not particularly limited. Examples of the method include a method of feeding the lead between these sheets with a known rotating roller.

The method for pasting the first elastomer sheet and the second elastomer sheet with each other is not particularly limited. Examples of the method include a method of passing these sheets between two pressure rollers in a state that these sheets closely adhere to each other, and a method of pressure-bonding these sheets with each other with a press machine.

The unloading step is a step of releasing the first elastomer sheet and the second elastomer sheet that are in the pasted state from elongation for unloading, to bring the lead into a state of being deformed into a wavy shape periodically curving in-plane in the facing surfaces of the first elastomer sheet and the second elastomer sheet and being biased in a direction to restore to the rod-like shape from the wavy shape.

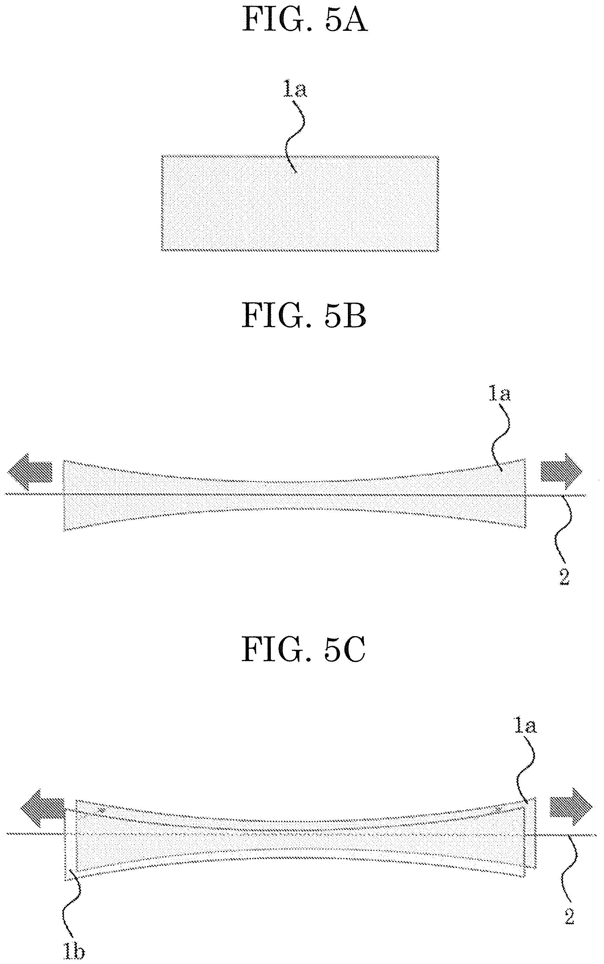

The method for producing the stretchable contractible wiring sheet of the present invention will be described with reference to FIG. 5A to FIG. 5C and FIG. 1A, based on an example of a method for producing a stretchable contractible wiring sheet 10 according to an embodiment of the present invention. FIG. 5A to FIG. 5C are views (1) to (3) illustrating a step pf producing a stretchable contractible wiring sheet 10.

First, a first elastomer sheet 1a, of which equilibrium length is indicated in FIG. 5A, is prepared. A tension is applied to the first elastomer sheet 1a in the lengthwise direction of the first elastomer sheet 1a, to elongate the first elastomer sheet 1a (see FIG. 5B).

Next, in the state that the first elastomer sheet 1a is elongated, a lead 2 having a rod-like shape is disposed on a surface of the first elastomer sheet 1a on which a viscous layer is formed, along the elongating direction of the first elastomer sheet 1a (see FIG. 5B).

Next, a second elastomer sheet 1b formed of the same material as the first elastomer sheet 1a is elongated in the same manner as elongating the first elastomer sheet 1a, and these sheets are pasted with each other in a state that the lead 2 having a rod-like shape is disposed between the first elastomer sheet 1a and the second elastomer sheet 1b (see FIG. 5C).

Next, the first elastomer sheet 1a and the second elastomer sheet 1b that are in the pasted state are released from elongation for unloading. Here, the lead 2 having a rod-like shape comes to be interposed between the first elastomer sheet 1a and the second elastomer sheet 1b in a state of being deformed into a wavy shape periodically curving in-plane in the facing surfaces of these sheets along with contraction of these sheets and being biased in a direction to restore to the rod-like shape from the wavy shape (see FIG. 1A).

In the way described above, the stretchable contractible wiring sheet 10 is produced.

Taking advantage of the stretchability/contractibility of the first elastomer sheet 1a and the second elastomer sheet 1b, this method for producing a stretchable contractible wiring sheet is a simple producing process of only disposing the lead 2 between the first elastomer sheet 1a and the second elastomer sheet 1b that are approximately elongated. Therefore, the stretchable contractible wiring sheet 10 can be produced extremely easily at low costs.

### (Apparatus for producing stretchable contractible wiring sheet)

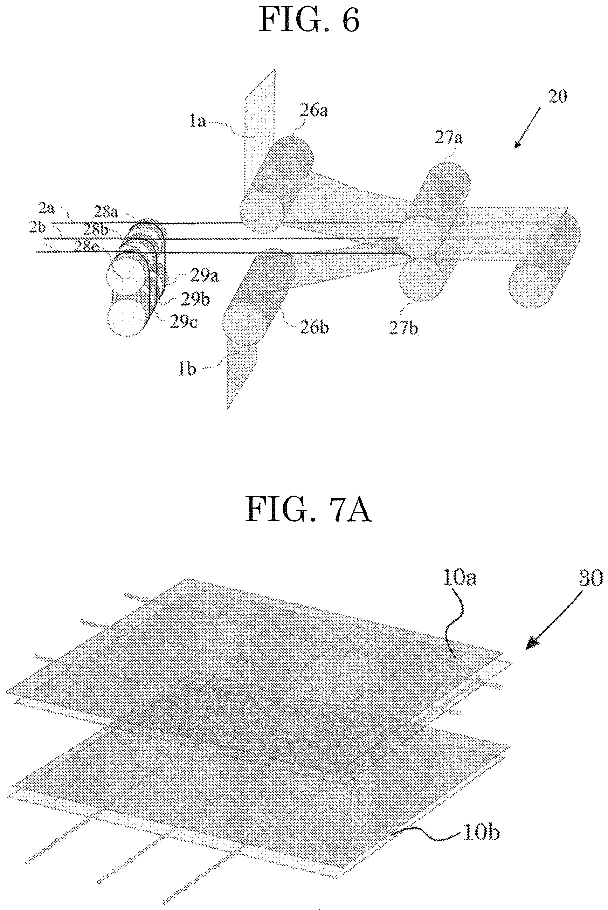

Next, an apparatus for producing a stretchable contractible wiring sheet of the present invention will be described with reference to FIG. 6. This producing apparatus is capable of mass production of the stretchable contractible wiring sheet by the above-described method for producing a stretchable contractible wiring sheet of the present invention. FIG. 6 is a view illustrating an example of the apparatus for producing a stretchable contractible wiring sheet.

As illustrated in FIG. 6, an apparatus 20 for producing a stretchable contractible wiring sheet includes a first elastomer sheet feeding roller 26a, a second elastomer sheet feeding roller 26b, pressure rollers 27a and 27b, lead feeding rollers 28, and a roller controlling unit (unillustrated) configured to control the rotating speeds of these rollers.

The pressure rollers 27a and 27b are capable of pressure-bonding a first elastomer sheet 1a and a second elastomer sheet 1b with each other by press-fitting the first elastomer sheet 1a, the second elastomer sheet 1b, and a lead 2 having a rod-like shape between the two rotating rollers in a manner that the lead 2 is interposed between these sheets, wherein an adhesive layer is formed on at least any one of facing surfaces of the first elastomer sheet 1a and the second elastomer sheet 1b.

The first elastomer sheet feeding roller 26a is capable of feeding the first elastomer sheet 1a toward the pressure rollers 27a and 27b. The second elastomer sheet feeding roller 26b is capable of feeding the second elastomer sheet 1b toward the pressure rollers 27a and 27b in a manner that the second elastomer sheet 1b faces the first elastomer sheet la.

The lead feeding rollers 28a, 28b, and 28c together with dancer rollers 29a, 29b, and 29c are provided between the first elastomer sheet feeding roller 26a and the second elastomer sheet feeding roller 26b, and are capable of feeding the lead 2 toward the pressure rollers 27a and 27b in a direction parallel with the feeding direction in which the first elastomer sheet 1a and the second elastomer sheet 1b are fed toward the pressure rollers 27a and 27b when seen from above a surface opposite to any one of the facing surfaces of the first elastomer sheet 1a and the second elastomer sheet 1b, with adjustment of the tension of the lead 2 by the motions of the dancer rollers 29a, 29b, and 29c.

The roller controlling unit is configured to control the sending-out speed of the pressure rollers 27a and 27b at a speed higher than the feeding speed of the first elastomer sheet feeding roller 26a and the second elastomer sheet feeding roller 26b, such that the first elastomer sheet 1a and the second elastomer sheet 1b fed from the first elastomer sheet feeding roller 26a and the second elastomer sheet feeding roller 26b are press-fitted into the pressure rollers 27a and 27b in a state that the first elastomer sheet 1a and the second elastomer sheet 1b are elongated in the feeding direction, while controlling the sending-out speed of the pressure rollers 27a and 27b at a speed equal to the feeding speed of the lead feeding rollers 28.

The stretchable contractible wiring sheet sent out from the pressure rollers 27a and 27b is cut into an intended size with a known cutting device.

The apparatus 20 for producing a stretchable contractible wiring sheet, configured as described above, is capable of mass production of stretchable contractible wiring sheets, by continuous feeding of the first elastomer sheet 1a, the second elastomer sheet 1b, and the lead 2.

### (Stretchable contractible touch sensor sheet)

Next, a stretchable contractible touch sensor sheet of the present invention will be described with reference to FIG. 7A. FIG. 7A is a view illustrating a configuration example of the stretchable contractible touch sensor sheet.

This stretchable contractible touch sensor sheet 30 is formed of two stretchable contractible wiring sheets of the present invention.

That is, the stretchable contractible touch sensor sheet 30 includes two stretchable contractible wiring sheets 10a and 10b that each include: the first elastomer sheet that is stretchable and contractible; the second elastomer sheet that is stretchable and contractible, and bonded on the first elastomer sheet in a manner to face the first elastomer sheet, and a plurality of leads that are formed side by side, and are each interposed between the first elastomer sheet and the second elastomer sheet in a state of having the wavy shape periodically curving in-plane in facing surfaces of the first elastomer sheet and the second elastomer sheet and being biased in a direction to restore to a rod-like shape from the wavy shape during unloading, wherein the first elastomer sheet and the second elastomer sheet are formed of a transparent material, and wherein the two stretchable contractible wiring sheets 10a and 10b are disposed in a manner to face each other in a state that a routing direction of the leads of one of the stretchable contractible wiring sheets and a routing direction of the leads of the other of the stretchable contractible wiring sheets are orthogonal.

The stretchable contractible touch sensor sheet 30 having this configuration can easily change shape in conformity with touch operations because the leads having the wavy shape are disposed being biased previously in a direction to deform upon receiving an external force, leading to an excellent operation feeling and an excellent sensitivity. The stretchable contractible touch sensor sheet 30 can endure shape changes in any of an elongating direction and a bending direction. Therefore, even when the installing place has a curved surface, the stretchable contractible touch sensor sheet 30 can be disposed in conformity with the curved surface.

The stretchable contractible touch sensor sheet 30 can be used as a conductive sheet for known touch sensors such as a resistance change-type touch sensor and a capacitance-type touch sensor.

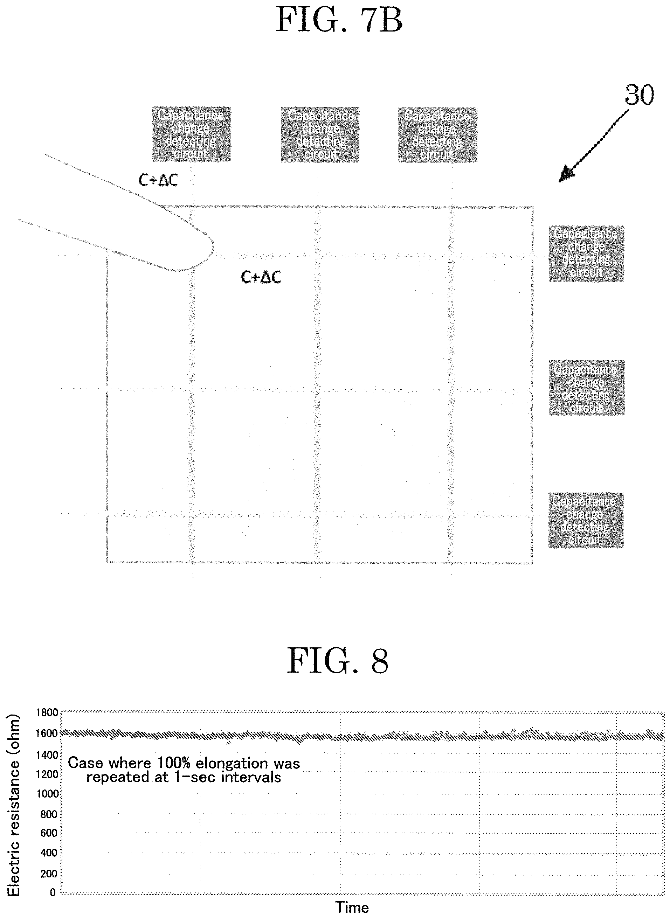

For example, a configuration example of a capacitance-type touch sensor is illustrated in FIG. 7B.

In this capacitance-type touch sensor, capacitance change detecting circuits are coupled to one-side ends of the leads that are disposed in a lengthwise-and-crosswise matrix formation and electrified, to detect capacitance changes of the stretchable contractible touch sensor sheet 30 along with touch operations.

In the illustrated example, one lead is constituted as one detection line. However, when an optimum resistance value for detection is difficult to obtain, a plurality of leads may be coupled to one capacitance change detecting circuit and configured as one detection line.

When the stretchable contractible touch sensor sheet 30 is used for the resistance change-type touch sensor, it is preferable to select the material of the leads in a manner that a resistance value change during stretching and contracting is 5% or lower. It is also preferable to design the resistance value of one detection line per unit length to 100 Ω/cm or less.

On the other hand, when the stretchable contractible touch sensor sheet 30 is used for the capacitance-type touch sensor, it is preferable to select the material of the leads in a manner that a resistance value change during stretching and contracting is 30% or lower. It is also preferable to design the resistance value of one detection line per unit length to 500 Ω/cm or less.

In the stretchable contractible touch sensor sheet 30, the first elastomer sheets and the second elastomer sheets constituting the stretchable contractible touch sensor sheet 30 are required to have a transparency corresponding to a visible light transmittance of 50% or higher in the state of being faced with each other, in consideration of visibility of stains on the touching surface and visibility of images on the display when seen through this touch sensor.

The haze value of the stretchable contractible touch sensor sheet 30 is preferably as low as possible (for example, 3%) in terms of transparency, and is preferably at most 60%. The haze value is measured by irradiating the sheet with visible light and measuring the ratio of diffuse transmitted light to total transmitted light.

The haze value can be adjusted based on, for example, the diameter of the leads and the intervals at which the leads are formed side by side.

Here, a relationship among the diameter of the leads, the distance to the touch sensor, and visibility of the leads is presented in Table 2 below.

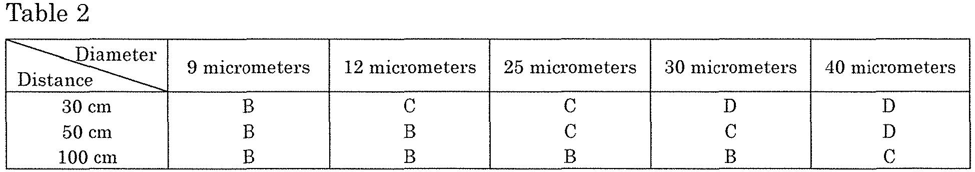

Table 2 presents subjective evaluation, where B indicates invisibility, C indicates slight visibility, and D indicates visibility.

Hence, when the stretchable contractible touch sensor sheet 30 is applied to a touch sensor for a high-definition panel or a high-definition printed matter, the diameter of the leads is preferably 12 micrometers or less.

On the other hand, when the stretchable contractible touch sensor sheet is used for an application in which a large-sized screen such as a vending machine and a digital signage is used, image high definition is not required, and the display is observed from a distance of 1 m or greater, the diameter of the leads may be about 40 micrometers or less.

When the intervals at which the leads are formed side by side are about from 100 micrometers through 10 mm, the haze value described above tends to be obtained.

As a further application, when the stretchable contractible touch sensor sheet is applied to a touch sensor for a foldable display of an information terminal such as a smart phone, the number of times the stretchable contractible touch sensor sheet can endure bending is preferably 100,000 times or greater, on the condition that the curvature radius of the wavy shape of the leads is 1 mm.

When the stretchable contractible touch sensor sheet is applied to a touch sensor for a wearable device for a sliding portion such as a human joint, a high stretchability/contractibility and a high durability are required. Hence, the elongation rate is preferably 50% or higher and the number of times of enduring bending is preferably 100,000 times or greater.

When the touch sensor is mounted on a curved surface in, for example, the interior of an automobile by pasting, the elongation rate is preferably 60% or higher and a resistance change rate of the leads is preferably 5% or lower.

### Examples

A stretchable contractible wiring sheet of an Example was produced according to the method for producing a stretchable contractible wiring sheet described above (see FIG. 5A to FIG. 5C), using commercially available urethane-based elastomer sheets having a limit elongation rate of 600% as the first elastomer sheet and the second elastomer sheet and a piano wire having a diameter of 12 micrometers as the lead. A commercially available urethane gel-based tackifier was used as a tackifier to be used for bonding the first elastomer sheet and the second elastomer sheet, and the initial elongation rate of the first elastomer sheet and the second elastomer sheet during pasting was set to 400%.

With voltmeters coupled to both ends of the lead, a load of 100% elongation was applied to the stretchable contractible wiring sheet of the Example in the routing direction of the lead 500 times at 1-seond intervals, to observe resistance value changes. The results are plotted in FIG. 8.

As plotted in FIG. 8, there was no significant resistance value change during the observation period, and the difference between the resistance value at the first time and the resistance value at the 500th time was not large. Therefore, it can be understood that the stretchable contractible wiring sheet of the Example underwent a small resistance value change along with shape change, and had a durability that would prevent the stretchable contractible wiring sheet from being torn even when stretched and contracted 500 times.

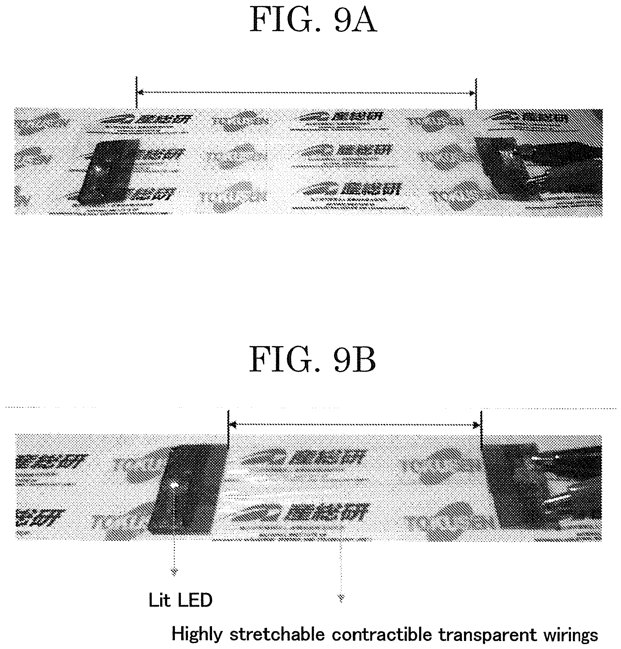

Next, with a LED device coupled to one end of the lead and a power supply device coupled to the other end of the lead, the stretchable contractible wiring sheet of the Example was elongated by 50% in the routing direction of the lead, to observe the lighting states of the LED device before and after elongation. The results are illustrated in FIG. 9A and FIG. 9B. FIG. 9A is a view illustrating the lighting state of the LED device after elongation. FIG. 9B is a view illustrating the lighting state of the LED device before elongation.

As illustrated in FIG. 9A and FIG. 9B, there was no difference between the lighting states of the LED device before and after elongation. It can be understood that the stretchable contractible wiring sheet of the Example had endurance against stretching and contracting.

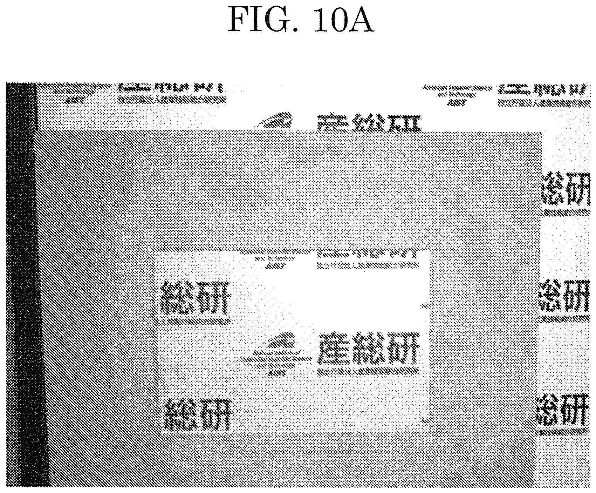

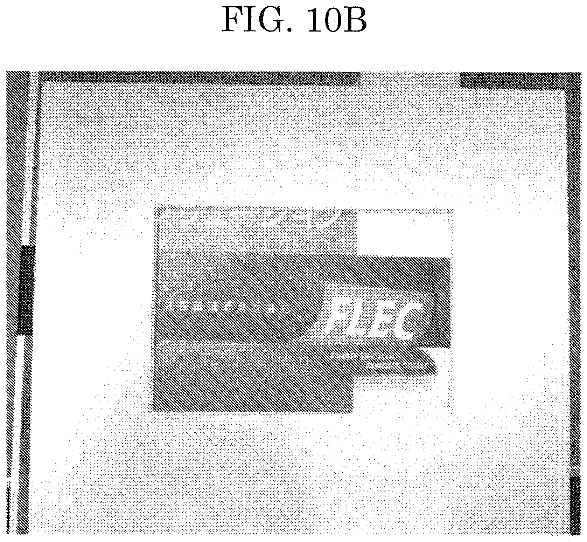

Next, in order to prove applicability to a touch sensor required to have transparency, the stretchable contractible wiring sheet of the Example was disposed on the surfaces of two displayed matters, to observe whether the two displayed matters were visible through the stretchable contractible wiring sheet of the Example. The observation states are illustrated in FIG. 10A and FIG. 10B. One of the two displayed matters was a light reflecting medium (FIG. 10A), and the other was a light emitting medium (FIG. 10B). Further, in order to confirm transparency for use as a touch sensor, two stretchable contractible wiring sheets of the Example were prepared and observed in a state that the two stretchable contractible wiring sheets were faced with each other.

As illustrated in FIG. 10A and FIG. 10B, an excellent visibility was confirmed for both of the displayed matters. It can be understood that the stretchable contractible wiring sheet of the Example can be applied to a touch sensor required to have transparency.

Next, two stretchable contractible wiring sheets of the Example were prepared. A stretchable contractible touch sensor sheet of Example was produced by laminating these two sheets in a state that the routing direction of the leads of one of the sheets and the routing direction of the leads of the other of the sheets were orthogonal, and a touch sensor having the same function as that of the capacitance-type touch sensor illustrated in FIG. 7B was produced by coupling the leads to capacitance change detecting circuits.

Tests for observing flexibility and bendability of the touch sensor using the stretchable contractible touch sensor sheet of the Example were performed.

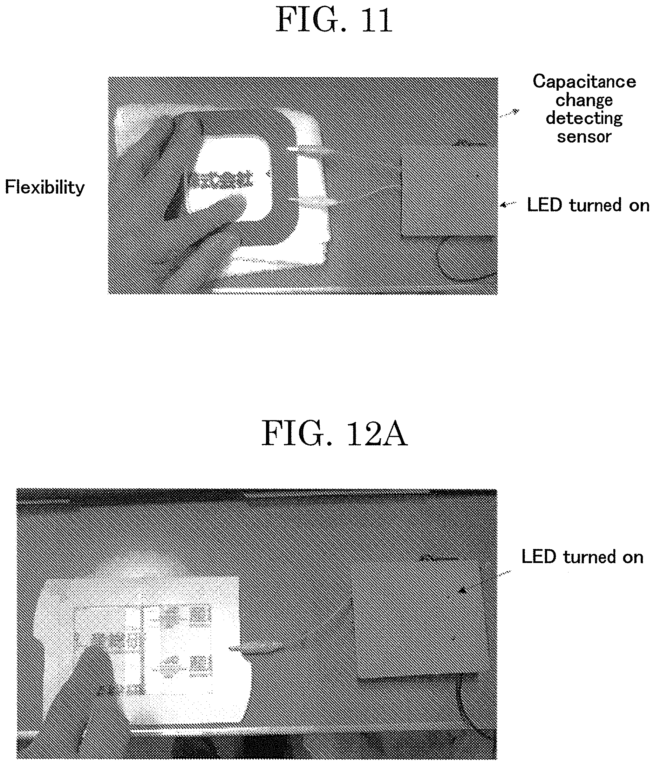

First, for flexibility, the touch sensor using the stretchable contractible touch sensor sheet of the Example was disposed on a soft cloth and pressed against the cloth, to observe whether the touch sensor would undergo shape change flexibly in conformity with the shape of the cloth. The result is illustrated in FIG. 11.

As illustrated in FIG. 11, it was confirmed that the touch sensor using the stretchable contractible touch sensor sheet of the Example had flexibility, because it underwent shape change flexibly in conformity with the shape of the cloth. It was also confirmed that the touch sensor was able to turn on a LED device before and after shape change, without undergoing, for example, tearing.

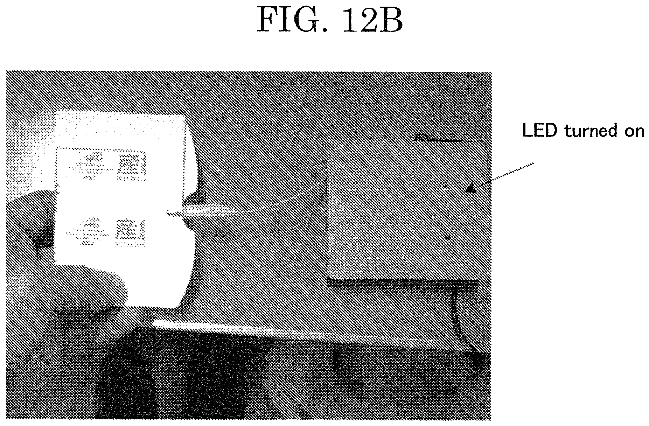

Next, for bendability, the touch sensor using the stretchable contractible touch sensor sheet of the Example was bent at approximately a center position in a folding manner, to observe lighting states of a LED device before and after bending. The results are illustrated in FIG. 12A and FIG. 12B. FIG. 12A is a view illustrating the lighting state before bending. FIG. 12B is a view illustrating the lighting state after bending.

As illustrated in FIG. 12A and FIG. 12B, it was confirmed that the touch sensor using the stretchable contractible touch sensor sheet of the Example kept the lighting state of the LED device unchanged between before and after bending.

### Reference Signs List

1a: first elastomer sheet
1b: second elastomer sheet
2: lead
3: viscous layer
10: stretchable contractible wiring sheet
20: apparatus for producing a stretchable contractible wiring sheet
26a: first elastomer sheet feeding roller
26b: second elastomer sheet feeding roller
27a, 27b: pressure roller
28a, 28b, 28c: lead feeding roller
29a, 29b, 29c: dancer roller

## Claims

1. A stretchable contractible wiring sheet (10), comprising:
a first elastomer sheet (1a) that is stretchable and contractible;
a second elastomer sheet (1b) that is stretchable and contractible, and bonded on the first elastomer sheet (1a) in a manner to face the first elastomer sheet (1a); and
a lead (2) interposed between the first elastomer sheet (1a) and the second elastomer sheet (1b) in a state of having a wavy shape periodically curving in a plane parallel to and between facing surfaces of the first elastomer sheet (1a) and the second elastomer sheet (1b) and being biased into said wavy shape periodically curving in a plane parallel and between in facing surfaces to restore to the shape of a straight line during unloading of said lead biased into said wavy shape by stretching said stretchable and contractible first (1a) and second (1b) elastomer sheet.

2. The stretchable contractible wiring sheet (10) according to claim 1,
wherein a cross-sectional shape of the lead (2) in a diameter direction is a circular shape.

3. The stretchable contractible wiring sheet (10) according to claim 1 or 2, wherein a diameter of the lead (2) is at most 50 micrometers.

4. The stretchable contractible wiring sheet (10) according to any one of claims 1 to 3,
wherein a Young's modulus of the lead (2) is at least 150 GPa.

5. The stretchable contractible wiring sheet (10) according to any one of claims 1 to 4,
wherein a wave height of the wavy shape is from 20 micrometers through 5 mm.

6. The stretchable contractible wiring sheet (10) according to any one of claims 1 to 5,
wherein a ratio A/B is from 0.05 through 0.5, where A represents a curvature radius of wave crests of waves in the wavy shape and B represents a periodic pitch interval between adjoining waves of the waves in the wavy shape.

7. A method for producing a stretchable contractible wiring sheet (10) according to any one of claim 1 to 6, the method comprising:
elongating a first elastomer sheet (1a) and a second elastomer sheet (1b) in one elongating direction in a state that the first elastomer sheet (1a) and the second elastomer sheet (1b) face each other, an adhesive layer being formed on at least any one of facing surfaces of the first elastomer sheet (1a) and the second elastomer sheet (1b);
disposing a lead (2) having a rod-like shape along the elongating direction between the first elastomer sheet (1a) and the second elastomer sheet (1b) that face each other, and pasting the first elastomer sheet (1a) and the second elastomer sheet (1b) with each other in a state that the lead (2) is interposed between the first elastomer sheet (1a) and the second elastomer sheet (1b); and
releasing the first elastomer sheet (1a) and the second elastomer sheet (1b)that are in a pasted state from elongation for unloading, to bring the lead (2) into a state of being deformed into a wavy shape periodically curving in a plane parallel to and between facing surfaces of the first elastomer sheet (1a) and the second elastomer sheet (1b) and into said wavy shape periodically curving in a plane parallel and between in facing surfaces to restore to the shape of a straight line.

8. An apparatus (20) configured to produce a stretchable contractible wiring sheet (10) according to any one of claims 1 to 6, the apparatus (20) comprising:
a pressure roller (27a, 27b) formed of two rotating rollers and capable of pressure-bonding a first elastomer sheet (1a) and a second elastomer sheet (1b) with each other by press-fitting the first elastomer sheet (1a), the second elastomer sheet (1b), and a lead (2) having a rod-like shape between the two rotating rollers in a manner that the lead (2) is interposed between the first elastomer sheet (1a) and the second elastomer sheet (1b), an adhesive layer being formed on at least any one of facing surfaces of the first elastomer sheet (1a) and the second elastomer sheet (1b);
a first elastomer sheet feeding roller (26a) capable of feeding the first elastomer sheet (1a) toward the pressure roller (27a, 27b);
a second elastomer sheet feeding roller (26b) capable of feeding the second elastomer sheet (1b) toward the pressure roller (27a, 27b) in a manner that the second elastomer sheet (1b) faces the first elastomer sheet (1a);
a lead feeding roller (28a, 28b, 28c) provided between the first elastomer sheet feeding roller (26a) and the second elastomer sheet feeding roller (26b) and capable of feeding the lead (2) toward the pressure roller (27a, 27b) in a direction parallel with a feeding direction in which the first elastomer sheet (1a) and the second elastomer sheet (1b) are fed toward the pressure roller (27a, 27b) when seen from above a surface opposite to any one of the facing surfaces of the first elastomer sheet (1a) and the second elastomer sheet (1b); and
a roller controlling unit configured to control a sending-out speed of the pressure roller (27a, 27b) at a speed higher than a feeding speed of the first elastomer sheet feeding roller (26a) and the second elastomer sheet feeding roller (26b), such that the first elastomer sheet (1a) and the second elastomer sheet (1b) fed from the first elastomer sheet feeding roller (26a) and the second elastomer sheet feeding roller (26b) are press-fitted into the pressure roller (27a, 27b) in a state that the first elastomer sheet (1a) and the second elastomer sheet (1b) are elongated in the feeding direction, while controlling the sending-out speed of the pressure roller (27a, 27b) at a speed equal to a feeding speed of the lead feeding roller (28a, 28b, 28c),
wherein the apparatus (20) configured to produce a stretchable contractible wiring sheet (10) is configured to release the first elastomer sheet (1a) and the second elastomer sheet (1b) that are in a pasted state from elongation for unloading, to bring the lead (2) into a state of being deformed into a wavy shape periodically curving in a plane parallel and between in facing surfaces of the first elastomer sheet (1a) and the second elastomer sheet (1b); wherein the apparatus comprises a dancer roller (29a, 29b, 29c) allowing for adjustment of the tension of the lead (2).

9. A stretchable contractible touch sensor sheet, comprising:
two stretchable contractible wiring sheets (10) that each comprise:
a first elastomer sheet (1a) that is stretchable and contractible;
a second elastomer sheet (1b) that is stretchable and contractible, and bonded on the first elastomer sheet (1a) in a manner to face the first elastomer sheet (1a), and
a plurality of leads (2) that are formed side by side, and are each interposed between the first elastomer sheet (1a) and the second elastomer sheet (1b) in a state of having a wavy shape periodically curving in a plane parallel to and between facing surfaces of the first elastomer sheet (1a) and the second elastomer sheet (1b) and being biased into said wavy shape periodically curving in a plane parallel and between in facing surfaces to restore to the shape of a straight line during unloading, of said lead biased into said wavy shape by stretching said stretchable and contractible first (1a) and second (1b) elastomer sheet,
the first elastomer sheet (1a) and the second elastomer sheet (1b) being formed of a transparent material,
the two stretchable contractible wiring sheets (10) being disposed in a manner to face each other in a state that a routing direction of the leads (2) of one of the stretchable contractible wiring sheets (10) and a routing direction of the leads (2) of the other of the stretchable contractible wiring sheets (10) are orthogonal.

10. The stretchable contractible touch sensor sheet according to claim 9,
wherein a haze value of the stretchable contractible touch sensor sheet is at most 60% or lower.

## Patentansprüche

1. Eine dehnbare, zusammenziehbare Verdrahtungsfolie (10), umfassend:
eine erste Elastomerfolie (1a), die dehnbar und zusammenziehbar ist;
eine zweite Elastomerfolie (1b), die dehnbar und zusammenziehbar ist und mit der ersten Elastomerfolie (1a) so verbunden ist, dass sie der ersten Elastomerfolie (1a) gegenüberliegt; und
eine Leitung (2), die zwischen der ersten Elastomerfolie (1a) und der zweiten Elastomerfolie (1b) in einem Zustand angeordnet ist, in dem sie eine Wellenform aufweist, die periodisch in einer Ebene parallel zu und zwischen einander zugewandten Oberflächen der ersten Elastomerfolie (1a) und der zweiten Elastomerfolie (1b) eine Krümmung aufweist und in die Wellenform vorgespannt ist, die periodisch in einer Ebene parallel zu und zwischen einander zugewandten Oberflächen eine Krümmung aufweist, um die Form einer geraden Linie während des Entladens der in die Wellenform vorgespannten Leitung durch Dehnen der dehnbaren und zusammenziehbaren ersten (1a) und zweiten (1b) Elastomerfolie wiederherzustellen.

2. Dehnbare, zusammenziehbare Verdrahtungsfolie (10) nach Anspruch 1,
wobei die Querschnittsform der Leitung (2) in Richtung des Durchmessers eine Kreisform hat.

3. Dehnbare, zusammenziehbare Verdrahtungsfolie (10) nach Anspruch 1 oder 2,
wobei der Durchmesser der Leitung (2) höchstens 50 Mikrometer beträgt.

4. Dehnbare, zusammenziehbare Verdrahtungsfolie (10) nach einem der Ansprüche 1 bis 3,
wobei Young's Elastizitätsmodul der Leitung (2) mindestens 150 GPa beträgt.

5. Dehnbare, zusammenziehbare Verdrahtungsfolie (10) nach einem der Ansprüche 1 bis 4,
wobei die Wellenhöhe der Wellenform von 20 Mikrometer bis 5 mm liegt.

6. Dehnbare, zusammenziehbare Verdrahtungsfolie (10) nach einem der Ansprüche 1 bis 5,
wobei ein Verhältnis A/B von 0,05 bis 0,5 liegt, wobei A einen Krümmungsradius der Wellenberge der Wellen in der Wellenform darstellt und B ein periodisches Teilungsintervall zwischen benachbarten Wellen der Wellen in der Wellenform darstellt.

7. Ein Verfahren zur Herstellung einer dehnbaren, zusammenziehbaren Verdrahtungsfolie (10) nach einem der Ansprüche 1 bis 6, wobei das Verfahren umfasst:
Ausziehen einer ersten Elastomer-Folie (1a) und einer zweiten Elastomer-Folie (1b) in einer Ausziehrichtung in einem Zustand, in dem die erste Elastomer-Folie (1a) und die zweite Elastomer-Folie (1b) einander zugewandt sind, wobei eine Klebstoffschicht auf mindestens einer der einander zugewandten Oberflächen der ersten Elastomer-Folie (1a) und der zweiten Elastomer-Folie (1b) ausgebildet ist;
Anordnen einer Leitung (2) mit einer stangenartigen Form entlang der Ausziehrichtung zwischen der ersten Elastomerfolie (1a) und der zweiten Elastomerfolie (1b), die einander zugewandt sind, und Verkleben der ersten Elastomerfolie (1a) und der zweiten Elastomerfolie (1b) miteinander zu einem Zustand, in dem die Leitung (2) zwischen der ersten Elastomerfolie (1a) und der zweiten Elastomerfolie (1b) angeordnet ist; und
Freigeben der ersten Elastomerfolie (1a) und der zweiten Elastomerfolie (1b), die sich in einem verklebten Zustand befinden, von dem Ausziehen zum Entladen, um die Leitung (2) in einen Zustand zu bringen, in dem sie in eine wellenförmige Form verformt wird, die periodisch in einer Ebene parallel zu und zwischen einander zugewandten Oberflächen der ersten Elastomerfolie (1a) und der zweiten Elastomerfolie (1b) eine Krümmung aufweist, und in die Wellenform, die periodisch in einer Ebene parallel zu und zwischen einander zugewandten Oberflächen eine Krümmung aufweist, um in die Form einer geraden Linie zurückzukehren.

8. Eine Vorrichtung (20) ausgelegt zur Herstellung einer dehnbaren, zusammenziehbaren Verdrahtungsfolie (10) nach einem der Ansprüche 1 bis 6, wobei die Vorrichtung (20) umfasst:
eine Druckwalze (27a, 27b), die aus zwei rotierenden Walzen gebildet ist und in der Lage ist, eine erste Elastomerfolie (1a) und eine zweite Elastomerfolie (1b) durch Presspassung der ersten Elastomerfolie (1a) und der zweiten Elastomerfolie (1b) miteinander zu verbinden, und eine Leitung (2) mit einer stangenartigen Form zwischen den beiden rotierenden Walzen in einer Weise, dass die Leitung (2) zwischen der ersten Elastomerfolie (1a) und der zweiten Elastomerfolie (1b) angeordnet ist, wobei eine Klebstoffschicht auf mindestens einer der einander zugewandten Oberflächen der ersten Elastomerfolie (1a) und der zweiten Elastomerfolie (1b) ausgebildet ist;
eine erste Elastomerfolien-Transportwalze (26a), die in der Lage ist, die erste Elastomerfolie (1a) in Richtung der Druckwalze (27a, 27b) zu transportieren;
eine zweite Elastomerfolien-Transportwalze (26b), die in der Lage ist, die zweite Elastomerfolie (1b) in Richtung der Druckwalze (27a, 27b) in einer Weise zu transportieren, dass die zweite Elastomerfolie (1b) der ersten Elastomerfolie (1a) gegenüberliegt;
eine Vorschubwalze (28a, 28b, 28c), die zwischen der ersten Elastomerfolien-Transportwalze (26a) und der zweiten Elastomerfolien-Transportwalze (26b) vorgesehen ist und die Leitung (2) zur Druckwalze (27a, 27b) in einer Richtung parallel zu einer Transportrichtung transportieren kann, in der die erste Elastomerfolie (1a) und die zweite Elastomerfolie (1b) zu der Druckwalze (27a, 27b) hin transportiert werden, wenn man sie von oberhalb einer Oberfläche aus betrachtet, die einer der einander zugewandten Oberflächen der ersten Elastomerfolie (1a) und der zweiten Elastomerfolie (1b) gegenüberliegt; und
eine Walzensteuereinheit, die so konfiguriert ist, dass sie eine Ausgabegeschwindigkeit der Druckwalze (27a, 27b) mit einer Geschwindigkeit steuert, die höher ist als eine Transportgeschwindigkeit der ersten Elastomerfolien-Transportwalze (26a) und der zweiten Elastomerfolien-Transportwalze (26b), so dass die erste Elastomerfolie (1a) und die zweite Elastomerfolie (1b), die von der ersten Elastomerfolien-Transportwalze (26a) und der zweiten Elastomerfolien-Transportwalze (26b) transportiert werden, in die Druckwalze (27a, 27b) in einem Zustand gepresst werden, so dass die erste Elastomerfolie (1a) und die zweite Elastomerfolie (1b) in der Transportrichtung ausgezogen werden, während die Ausstoßgeschwindigkeit der Druckwalze (27a, 27b) mit einer Geschwindigkeit gesteuert wird, die gleich einer Transportgeschwindigkeit der Vorschubwalze (28a, 28b, 28c) ist,
wobei die Vorrichtung (20) ausgelegt zur Herstellung einer dehnbaren, zusammenziehbaren Verdrahtungsfolie (10) so konfiguriert ist, dass sie die erste Elastomerfolie (1a) und die zweite Elastomerfolie (1b), die sich in einem verklebten Zustand befinden, von der Ausziehung zum Entladen freigibt, um die Leitung (2) in einen Zustand zu bringen, in dem sie in eine Wellenform verformt wird, die periodisch in einer Ebene parallel zu und zwischen einander zugewandten Oberflächen der ersten Elastomerfolie (1a) und der zweiten Elastomerfolie (1b) eine Krümmung aufweist;
wobei die Vorrichtung eine Tänzerwalze (29a, 29b, 29c) umfasst, die die Einstellung der Spannung der Leitung (2) ermöglicht.

9. Eine dehnbare, zusammenziehbare Berührungssensorfolie, umfassend:
zwei dehnbare, zusammenziehbare Verdrahtungsfolien (10), die jeweils Folgendes umfassen:
eine erste Elastomerfolie (1a), die dehnbar und zusammenziehbar ist;
eine zweite Elastomerfolie (1b), die dehnbar und zusammenziehbar ist und mit der ersten Elastomerfolie (1a) so verbunden ist, dass sie der ersten Elastomerfolie (1a) gegenüberliegt, und
eine Vielzahl von Leitungen (2), die nebeneinander ausgebildet sind und jeweils zwischen der ersten Elastomerfolie (1a) und der zweiten Elastomerfolie (1b) in einem Zustand angeordnet sind, so dass sie eine Wellenform aufweisen, die periodisch in einer Ebene parallel zu und zwischen einander zugewandten Oberflächen der ersten Elastomerfolie (1a) und der zweiten Elastomerfolie (1b) eine Krümmung aufweist, und in die Wellenform vorgespannt sind, die periodisch in einer Ebene parallel zu und zwischen einander zugewandten Oberflächen eine Krümmung aufweist, um während des Entladens der in die Wellenform vorgespannten Leitung durch Dehnen der dehnbaren und zusammenziehbaren ersten (1a) und zweiten (1b) Elastomerfolie, wieder die Form einer geraden Linie anzunehmen,
wobei die erste Elastomerfolie (1a) und die zweite Elastomerfolie (1b) aus einem transparenten Material gebildet sind,
wobei die beiden dehnbaren, zusammenziehbaren Verdrahtungsfolien (10) so angeordnet sind, dass sie einander in einem Zustand gegenüberliegen, in dem eine Führungsrichtung der Leitungen (2) eines der dehnbaren, zusammenziehbaren Verdrahtungsfolien (10) und eine Führungsrichtung der Leitungen (2) der anderen der dehnbaren, zusammenziehbaren Verdrahtungsfolien (10) zueinander orthogonal sind.

10. Dehnbare, zusammenziehbare Berührungssensorfolie nach Anspruch 9,
wobei ein Trübungswert der dehnbaren, zusammenziehbaren Berührungssensorfolie höchstens 60 % oder weniger beträgt.

## Revendications

1. Feuille de câblage étirable - contractable (10), comprenant :
une première feuille en élastomère (1a) qui est étirable et contractable ;
une seconde feuille en élastomère (1b) qui est étirable et contractable, et qui est fixée sur la première feuille en élastomère (1a) de telle sorte qu'elle fasse face à la première feuille en élastomère (1a) ; et
une connexion conductrice (2) qui est interposée entre la première feuille en élastomère (1a) et la seconde feuille en élastomère (1b) dans un état dans lequel elle présente une forme ondulée qui présente une courbure selon une période dans un plan qui est parallèle à des surfaces se faisant face de la première feuille en élastomère (1a) et de la seconde feuille en élastomère (1b) et qui est situé entre ces mêmes surfaces et dans lequel elle est sollicitée selon ladite forme ondulée qui présente une courbure selon une période dans un plan qui est parallèle à des surfaces se faisant face et qui est situé entre ces mêmes surfaces afin de restaurer la forme d'une ligne rectiligne pendant le déchargement de ladite connexion conductrice qui est sollicitée selon ladite forme ondulée en étirant lesdites première (1a) et seconde (1b) feuilles en élastomère étirables et contractables.

2. Feuille de câblage étirable - contractable (10) selon la revendication 1,
dans laquelle une forme en coupe transversale de la connexion conductrice (2) dans une direction de diamètre est une forme circulaire.

3. Feuille de câblage étirable - contractable (10) selon la revendication 1 ou 2,
dans laquelle un diamètre de la connexion conductrice (2) est d'au plus 50 micromètres.

4. Feuille de câblage étirable - contractable (10) selon l'une quelconque des revendications 1 à 3,
dans laquelle un module de Young de la connexion conductrice (2) est d'au moins 150 GPa.

5. Feuille de câblage étirable - contractable (10) selon l'une quelconque des revendications 1 à 4,
dans laquelle une hauteur d'ondulation de la forme ondulée est comprise entre 20 micromètres et 5 millimètres.

6. Feuille de câblage étirable - contractable (10) selon l'une quelconque des revendications 1 à 5,
dans laquelle un rapport A/B est compris entre 0,05 et 0,5, où A représente un rayon de courbure de crêtes d'ondulation d'ondulations dans la forme ondulée et B représente un intervalle de pas périodique entre des ondulations contiguës des ondulations dans la forme ondulée.

7. Procédé pour produire une feuille de câblage étirable - contractable (10) selon l'une quelconque des revendications 1 à 6, le procédé comprenant :
l'allongement d'une première feuille en élastomère (1a) et d'une seconde feuille en élastomère (1b) dans une direction d'allongement dans un état dans lequel la première feuille en élastomère (1a) et la seconde feuille en élastomère (1b) se font face l'une l'autre, une couche adhésive étant formée sur au moins l'une quelconque de surfaces se faisant face de la première feuille en élastomère (1a) et de la seconde feuille en élastomère (1b) ;
la disposition d'une connexion conductrice (2) qui présente une forme du type tige suivant la direction d'allongement entre la première feuille en élastomère (1a) et la seconde feuille en élastomère (1b) qui se font face l'une l'autre, et le collage de la première feuille en élastomère (1a) et de la seconde feuille en élastomère (1b) l'une à l'autre dans un état dans lequel la connexion conductrice (2) est interposée entre la première feuille en élastomère (1a) et la seconde feuille en élastomère (1b) ; et
la libération de la première feuille en élastomère (1a) et de la seconde feuille en élastomère (1b) qui sont dans un état collé vis-à-vis de leur allongement pour le déchargement, afin d'amener la connexion conductrice (2) dans un état dans lequel elle est déformée selon une forme ondulée qui présente une courbure selon une période dans un plan qui est parallèle à des surfaces se faisant face de la première feuille en élastomère (1a) et de la seconde feuille en élastomère (1b) et qui est situé entre ces mêmes surfaces et dans lequel elle est sollicitée selon ladite forme ondulée qui présente une courbure selon une période dans un plan qui est parallèle à des surfaces se faisant face et qui est situé entre ces mêmes surfaces afin de restaurer la forme d'une ligne rectiligne.

8. Appareil (20) configuré pour produire une feuille de câblage étirable - contractable (10) selon l'une quelconque des revendications 1 à 6, l'appareil (20) comprenant :
un rouleau de pression (27a, 27b) qui est formé par deux rouleaux rotatifs et qui permet de fixer par pression une première feuille en élastomère (1a) et une seconde feuille en élastomère (1b) l'une à l'autre par ajustement par pression de la première feuille en élastomère (1a), de la seconde feuille en élastomère (1b) et d'une connexion conductrice (2) qui présente une forme du type tige entre les deux rouleaux rotatifs de telle sorte que la connexion conductrice (2) soit interposée entre la première feuille en élastomère (1a) et la seconde feuille en élastomère (1b), une couche adhésive étant formée sur au moins l'une quelconque de surfaces se faisant face de la première feuille en élastomère (1a) et de la seconde feuille en élastomère (1b) ;
un rouleau d'alimentation de première feuille en élastomère (26a) qui permet d'alimenter la première feuille en élastomère (1a) en direction du rouleau de pression (27a, 27b) ;
un rouleau d'alimentation de seconde feuille en élastomère (26b) qui permet d'alimenter la seconde feuille en élastomère (1b) en direction du rouleau de pression (27a, 27b) de telle sorte que la seconde feuille en élastomère (1b) fasse face à la première feuille en élastomère (1a) ;
un rouleau d'alimentation de connexion conductrice (28a, 28b, 28c) qui est prévu entre le rouleau d'alimentation de première feuille en élastomère (26a) et le rouleau d'alimentation de seconde feuille en élastomère (26b) et qui permet d'alimenter la connexion conductrice (2) en direction du rouleau de pression (27a, 27b) dans une direction qui est parallèle à une direction d'alimentation dans laquelle la première feuille en élastomère (1a) et la seconde feuille en élastomère (1b) sont alimentées en direction du rouleau de pression (27a, 27b) tel que vu depuis au-dessus d'une surface qui est opposée à l'une quelconque des surfaces se faisant face de la première feuille en élastomère (1a) et de la seconde feuille en élastomère (1b) ; et
une unité de commande de rouleau qui est configurée pour commander une vitesse d'envoi du rouleau de pression (27a, 27b) à une vitesse qui est supérieure à une vitesse d'alimentation du rouleau d'alimentation de première feuille en élastomère (26a) et du rouleau d'alimentation de seconde feuille en élastomère (26b) de telle sorte que la première feuille en élastomère (1a) et la seconde feuille en élastomère (1b) qui sont alimentées depuis le rouleau d'alimentation de première feuille en élastomère (26a) et le rouleau d'alimentation de seconde feuille en élastomère (26b) soient ajustées par pression à l'intérieur du rouleau de pression (27a, 27b) dans un état dans lequel la première feuille en élastomère (1a) et la seconde feuille en élastomère (1b) sont allongées dans la direction d'alimentation, tout en commandant la vitesse d'envoi du rouleau de pression (27a, 27b) à une vitesse qui est égale à une vitesse d'alimentation du rouleau d'alimentation de connexion conductrice (28a, 28b, 28c) ;
dans lequel l'appareil (20) qui est configuré pour produire une feuille de câblage étirable - contractable (10) est configuré pour libérer la première feuille en élastomère (1a) et la seconde feuille en élastomère (1b) qui sont dans un état collé vis-à-vis de leur allongement pour le déchargement, afin d'amener la connexion conductrice (2) dans un état dans lequel elle est déformée selon une forme ondulée qui présente une courbure selon une période dans un plan qui est parallèle à des surfaces se faisant face de la première feuille en élastomère (1a) et de la seconde feuille en élastomère (1b) et qui est situé entre ces mêmes surfaces ; et
dans lequel l'appareil comprend un rouleau compensateur (29a, 29b, 29c) qui permet le réglage de la tension de la connexion conductrice (2).

9. Feuille de capteur tactile étirable - contractable, comprenant :
deux feuilles de câblage étirables - contractables (10) dont chacune comprend :
une première feuille en élastomère (1a) qui peut être étirée et contractée ;
une seconde feuille en élastomère (1b) qui peut être étirée et contractée et qui est fixée sur la première feuille en élastomère (1a) de telle sorte qu'elle fasse face à la première feuille en élastomère (1a) ; et
une pluralité de connexions conductrices (2) qui sont formées côte à côte et dont chacune est interposée entre la première feuille en élastomère (1a) et la seconde feuille en élastomère (1b) dans un état dans lequel elle présente une forme ondulée qui présente une courbure selon une période dans un plan qui est parallèle à des surfaces se faisant face de la première feuille en élastomère (1a) et de la seconde feuille en élastomère (1b) et qui est situé entre ces mêmes surfaces et dans lequel elle est sollicitée selon ladite forme ondulée qui présente une courbure selon une période dans un plan qui est parallèle à des surfaces se faisant face et qui est situé entre ces mêmes surfaces afin de restaurer la forme d'une ligne rectiligne pendant le déchargement de ladite connexion conductrice qui est sollicitée selon ladite forme ondulée en étirant lesdites première (1a) et seconde (1b) feuilles en élastomère étirables et contractables ;
la première feuille en élastomère (1a) et la seconde feuille en élastomère (1b) étant formées en un matériau transparent ; et
les deux feuilles de câblage étirables - contractables (10) étant disposées de telle sorte qu'elles se fassent face l'une l'autre dans un état dans lequel une direction de cheminement des connexions conductrices (2) de l'une des feuilles de câblage étirables - contractables (10) et une direction de cheminement des connexions conductrices (2) de l'autre des feuilles de câblage étirables - contractables (10) sont orthogonales.

10. Feuille de capteur tactile étirable - contractable selon la revendication 9,
dans lequel une valeur de turbidité de la feuille de capteur tactile étirable - contractable est d'au plus 60 % ou moins.
